# EUROPÄISCHE PATENTSCHRIFT

(11) **EP 2 225 782 B1**
(45) Veröffentlichungstag und Bekanntmachung des Hinweises auf die Patenterteilung: **03.07.2019**
(21) Anmeldenummer: 08868217.4
(22) Anmeldetag: 19.12.2008
(51) Int. Cl.: H01L 33/22, H01L 33/40, H01L 33/46

(54) **VERFAHREN ZUR HERSTELLUNG EINES STRAHLUNGSEMITTIERENDEN KÖRPERS**
METHOD FOR PRODUCING A RADIATION-EMITTING BODY
PROCÉDÉ POUR PRODUIRE UN CORPS ÉMETTEUR DE RAYONNEMENT

(30) Priorität: 27.12.2007 DE 102007062790; 21.05.2008 DE 102008024517
(43) Veröffentlichungstag der Anmeldung: 08.09.2010
(73) Patentinhaber: OSRAM Opto Semiconductors GmbH, 93055 Regensburg (DE)
(72) Erfinder: EBERHARD, Franz, 93059 Regensburg (DE); WINDISCH, Reiner, 93186 Pettendorf (DE); WALTER, Robert, 92331 Parsberg (DE); SCHMAL, Michael, 92287 Schmidmühlen (DE); AHLSTEDT, Magnus, 93049 Regensburg (DE)
(74) Vertreter: Epping - Hermann - Fischer
(86) Internationale Anmeldenummer: PCT/DE2008/002136
(87) Internationale Veröffentlichungsnummer: WO 2009/083001

(56) Entgegenhaltungen:
- EP-A- 1 845 564
- WO-A1-2007/136097
- DE-A1-102006 017 573
- GB-A- 2 453 464
- US-A1- 2006 011 923
- US-A1- 2007 012 933
- US-A1- 2007 080 352
- US-A1- 2007 176 162
- US-A1- 2007 194 324
- US-A1- 2007 275 489

## Beschreibung

Es wird ein Verfahren zur Herstellung eines strahlungsemittierenden Körpers angegeben. Bei dem Verfahren wird eine Schichtenfolge auf einem Substrat, mit einer aktiven Schicht zur Erzeugung von elektromagnetischer Strahlung, ausgebildet.

In der Druckschrift DE 10 2007 002 416 A1 ist ein strahlungsemittierender Körper und ein Verfahren zur Herstellung eines strahlungsemittierenden Körpers beschrieben.

Die Druckschrift US 2007/0 176 162 A1 beschreibt eine Leuchtdiode und die Druckschrift DE 10 2006 017 573 A1 beschreibt einen optoelektronischen Halbleiterkörper und ein Verfahren zu dessen Herstellung.

Aus der Druckschrift WO 2007/136097 A1 ist ein LED-Chip mit einem Ti-Ag-Ti-Spiegel bekannt.

Es ist eine Aufgabe der Erfindung, ein effizientes Verfahren zur Herstellung eines strahlungsemittierenden Körpers anzugeben.

Diese Aufgabe wird gelöst, wobei die aktive Schicht auf einer zur Reflexionsschicht gerichteten Grenzfläche eine Aufrauung aufweist und die Reflexionsschicht an einer zur aktiven Schicht gerichteten Grenzfläche im Wesentlichen planar ist.

Als planar ist dabei eine glatte Oberfläche zu verstehen, welche auch im mikroskopischen Maßstab noch nahezu frei von Rauigkeiten ist.

Die Aufgabe wird durch das Verfahren des Anspruchs 1 gelöst, indem ein Aufrauen einer Grenzfläche der aktiven Schicht, ein Ausbilden der zumindest einen Zwischenschicht und ein Ausbilden einer Reflexionsschicht erfolgt.

Eine zur Reflexionsschicht gerichtete Grenzfläche der aktiven Schicht ist auf ihrer Oberfläche aufgeraut. Die Reflexionsschicht ist an ihrer zur aktiven Schicht gerichteten Grenzfläche planar ausgebildet. Eine von der aktiven Schicht emittierte elektromagnetische Strahlung wird an der Aufrauung der Grenzfläche der aktiven Schicht gestreut, die gestreute elektromagnetische Strahlung wird an der Reflexionsschicht zurück reflektiert. Mit den beschriebenen Maßnahmen wird somit eine Trennung der physikalischen Effekte der Streuung und der Reflexion erreicht.

Der Vorteil dabei ist, dass ein Effekt vermieden ist, der als anormaler Skineffekt bezeichnet wird. Der anormale Skineffekt führt bei elektromagnetischer Strahlung, im besonderen auch bei elektromagnetischen Strahlen, deren Wellenlängen im sichtbaren Bereich des Lichtes liegen, zu einer teilweisen Absorption der Energie der Strahlung und verringert damit die Energie der ausgekoppelten elektromagnetischen Strahlen.

Der anormale Skineffekt beruht auf einer Oberflächenabsorption. Mikrorauigkeiten der Oberflächen können die Absorption im infraroten Wellenlängenbereich elektromagnetischer Wellen um 50 % steigern. Dieser Anstieg der Absorption tritt auch bei Rauigkeiten auf, die zu klein sind, um diffuse Streuung im infraroten Wellenlängenbereich zu verursachen. Jedes Material weist eine spezifisch optische Eindringtiefe für elektromagnetische Wellen auf, wobei diese optische Eindringtiefe abhängig von der jeweiligen Wellenlänge ist. Die optische Eindringtiefe beschreibt den Weg, den die elektromagnetische Strahlung in einem Material zurückgelegt hat, nachdem die Intensität bei einem senkrechtem Einfall um einen vorbestimmten Anteil abgenommen hat. Für Wellenlängen im infraroten Wellenlängenbereich beträgt die Eindringtiefe zum Beispiel bei Silber 22 nm bei Raumtemperatur. Bei anderen Materialien, wie Gold oder Kupfer, liegt die Eindringtiefe ähnlich bei etwa 20 nm für eine Wellenlänge von 10 µm.

Dieser anormale Skineffekt tritt zum Beispiel auch dann auf, wenn eine elektromagnetische Welle mit einer Wellenlänge im Bereich des sichtbaren Lichts auf eine Grenzfläche trifft, welche so ausgebildet ist, dass sie streuende und reflektierende Eigenschaften aufweist. Die Erfindung vermeidet in vorteilhafter Weise diesen Effekt. Durch die Trennung der physikalischen Effekte Streuung und Reflexion eines elektromagnetischen Strahles, eines Lichtstrahles, welche durch getrennte Ausbildung einer Grenzfläche mit streuenden Eigenschaften und einer Grenzfläche mit reflektierenden Eigenschaften erreicht wird, wird die Absorption von Energie durch den anormalen Skineffekt vermieden. Somit ist eine Erhöhung der Effizienz der Strahlungsauskopplung des strahlungsemittierenden Körpers erreicht.

Die Zwischenschicht ist für die vom aktiven Bereich erzeugte elektromagnetische Welle im Wesentlichen durchlässig. Somit durchquert die auf die Zwischenschicht auftreffende elektromagnetische Welle die Zwischenschicht und wird an der Reflexionsschicht reflektiert.

Es weist das Material der Zwischenschicht einen Brechungsindex auf, der sich von dem Brechungsindex des Materials der aktiven Schicht unterscheidet, bevorzugt ist der Brechungsindex des Materials der Zwischenschicht kleiner als der Brechungsindex des Materials der aktiven Schicht. Der Brechungsindex ist eine physikalische Größe in der Optik. Sie kennzeichnet die Brechung einer elektromagnetischen Welle beim Übergang zwischen zwei Medien.

Die Aufrauung ist dadurch gebildet, dass die Oberfläche der aktiven Schicht und damit die Grenzfläche zwischen der aktiven Schicht und der Zwischenschicht eine laterale Strukturierung aus einer Vielzahl von hervorstehenden Strukturelementen aufweist.

Vorstehend und im Folgenden sind Effekte und Eigenschaften des strahlungsemittierenden Körpers mittels einer Frequenz oder einer Wellenlänge einer elektromagnetischen Strahlung beschrieben. Als elektromagnetische Strahlung beziehungsweise elektromagnetische Welle ist eine Welle aus gekoppelten elektrischen und magnetischen Feldern bezeichnet. Zu ihnen gehören unter anderem Radiowellen, Mikrowellen, Infrarotstrahlung, sichtbares Licht, UV-Strahlung sowie Röntgen- und Gammastrahlung - kurz, das gesamte elektromagnetische Wellenspektrum. Der einzige Unterschied zwischen diesen Wellentypen liegt jeweils in ihrer Frequenz und somit auch in ihrer Energie.

Die Schichtenfolge des strahlungsemittierenden Körpers umfasst eine Halbleiterschichtenfolge. Diese wiederum umfasst die aktive Schicht, welche einen pn-Übergang aufweist. Ein pn-Übergang bezeichnet einen Materialübergang von Halbleiterkristallen mit andersartiger Dotierung, also Bereiche, in denen die Dotierung von negativ (n) zu positiv (p) wechselt. Die Besonderheit des pn-Übergangs ist die Ausbildung einer Raumladungszone, in der Armut an freien Ladungsträgern herrscht, sowie eines internen elektrischen Feldes, einer so genannten Sperrschicht, solange keine elektrische Spannung an dem Bauelement angelegt ist. Beispielsweise kann die aktive Schicht eine Quantentopfstruktur aufweisen, wobei die Quantentopfstruktur jegliche Struktur bezeichnet, bei der Ladungsträger durch Einschluss eine Quantisierung ihrer Energiezustände erfahren. Unter einem Quantentopf versteht man einen Potentialverlauf, der die Bewegungsfreiheit eines Teilchens in einer Raumdimension einschränkt, so dass nur eine planare Region besetzt werden kann. Die Breite des Quantentopfes bestimmt maßgeblich die quantenmechanischen Zustände, die das Teilchen einnehmen kann. Dies führt insbesondere zur Ausbildung von Energie-Niveaus. Dann kann das Teilchen nur diskrete, potentielle Energiewerte annehmen. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen. Die Schichtenfolge enthält ein auf Phosphid basierendes Verbindungshalbleitermaterial. Dieses Materialn ist zur Erzeugung von Strahlung einer Wellenlänge hauptsächlich im infraroten Bereich des optischen Spektrums geeignet.

Auf Phosphid basierendes Verbindungshalbleitermaterial bedeutet in diesem Zusammenhang, dass das Material vorzugsweise AlₙGaₘIn₁₋ₙ₋ₘP mit 0 ≤ n ≤ 1, 0 ≤ m ≤ 1 und n + m ≤ 1 umfasst. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, welche die physikalischen Eigenschaften des Materials im Wesentlichen aber nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Auf Phosphid basierendes Verbindungshalbleitermaterial bedeutet in diesem Zusammenhang auch, dass das Material vorzugsweise GaₙIn₁₋ₙAsmP₁₋ₘ mit 0 ≤ n ≤ 1, 0 ≤ m ≤ 1 umfasst. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, welche die physikalischen Eigenschaften des Materials im Wesentlichen aber nicht ändern. Der Einfachheit halber beinhaltet obige Formel jedoch nur die wesentlichen Bestandteile des Kristallgitters (Ga, In, As, P), auch wenn diese teilweise durch geringe Mengen weiterer Stoffe ersetzt sein können.

Vorzugsweise ist der strahlungsemittierende Körper ein Dünnfilmhalbleiterkörper. Das heißt, ein Aufwachssubstrat für den epitaktisch hergestellten strahlungsemittierenden Körper ist gedünnt oder ganz entfernt. Ein Grundprinzip eines Dünnfilmhalbleiterkörpers ist beispielsweise in I. Schnitzer et al., Appl. Phys. Lett. 63 (16), 18. Oktober 1993, 2174 bis 2176 beschrieben.

Ein strahlungsemittierender Dünnfilmhalbleiterkörper ist in guter Näherung ein Lambertscher Oberflächenstrahler und eignet sich besonders gut für Hinterleuchtungs-, Beleuchtungs- beziehungsweise Anzeigezwecke. Ein Lambert-Strahler ist ein physikalisch idealer Strahler. Die Strahldichte beziehungsweise die Leuchtdichte eines Lambertschen Strahlers ist nach allen Richtungen konstant.

Die Strukturelemente auf der Grenzfläche der aktiven Schicht zur Zwischenschicht sind besonders wirksam, wenn sie wahlweise eine Strukturgröße aufweisen, die größer ist als die Wellenlänge der durch die Strukturelemente hindurch tretenden Strahlung.

Vorliegend ist unter der Strukturgröße vorzugsweise mindestens eine der Größen Strukturbreite oder Strukturtiefe zu verstehen. Als Strukturbreite ist die Breite des Strukturelements, gemessen in lateraler Richtung, und als Strukturtiefe die Tiefe des Strukturelements, gemessen in vertikaler Richtung, bezeichnet.

Die Reflexionsschicht enthält ein Metall oder ist als metallische Schicht ausgebildet. Erfindungsgemäß umfasst diese metallische Schicht eine Folge von Metallisierungsschichten aus Ti-Ag-Ti (Titan-Silber-Titan). Die verschiedenen Metalle haben dabei verschiedene Aufgaben, so dient die erste Ti-Schicht als Haftvermittler, gefolgt von einer Ag-Schicht, die als Reflektor wirkt. Die zweite Ti-Schicht dient als Schutzschicht bei nachfolgenden Prozessen bei der Herstellung des strahlungsemittierenden Körpers. Auch die als Haftvermittlerschicht fungierende erste Ti-Schicht hat einen Einfluss auf die Reflexion und ist Teil der Reflexionsschicht. Vorteilhafterweise kann durch die metallische Schicht oder Schichtenfolge der strahlungsemittierende Körper mittels der Reflexionsschicht elektrisch abgeschlossen werden. In Verbindung mit einer metallisierten Reflexionsschicht und einer elektrisch leitfähigen Zwischenschicht lässt sich vorteilhafterweise eine elektrische Versorgung des aktiven Bereichs des strahlungsemittierenden Körpers bilden.

Die Zwischenschicht ist elektrisch leitend ausgebildet. Dabei ist für die elektrisch leitende Zwischenschicht ein TCO (transparent conductive oxide), insbesondere ITO (Indium Tin Oxide), IZO (Indium Zinc Oxide) oder ZnO (Zinkoxid), besonders geeignet. Vorteilhafterweise kann mit einer elektrisch leitenden Zwischenschicht die Reflexionsschicht als elektrischer Kontakt des strahlungsemittierenden Körpers dienen und die Versorgung der aktiven Schicht mit elektrischer Energie kann über die Reflexionsschicht und die Zwischenschicht geführt werden.

Wie bereits beschrieben ist die Grenzfläche der aktiven Schicht zur Zwischenschicht aufgeraut. Dabei können die Strukturelemente zumindest in Teilen unterschiedliche Strukturgrößen aufweisen. Des Weiteren können die Strukturelemente unregelmäßig auf der Grenzfläche verteilt sein. Zur Erzielung einer lateralen Strukturierung mit einer Mehrzahl von hervorstehenden Strukturelementen auf der Grenzfläche kann eine an die Zwischenschicht angrenzende Oberfläche der aktiven Schicht eine Mehrzahl von Strukturelementen aufweisen. Die Zwischenschicht ist auf der Oberfläche der aktiven Schicht aufgebracht. Demzufolge ist die zur aktiven Schicht gerichtete Oberfläche der Zwischenschicht mit der Struktur der Oberfläche der aktiven Schicht formschlüssig.

Im Folgenden wird das Verfahren zur Herstellung des strahlungsemittierenden Körpers angegeben.

Das Verfahren zur Herstellung eines strahlungsemittierenden Körpers weist die im Folgenden beschriebenen Schritte auf. Nachfolgend zur Erzeugung der aktiven Schicht erfolgen ein Aufrauen einer Grenzfläche auf der aktiven Schicht und ein Ausbilden zumindest einer Zwischenschicht. Weiter wird eine Reflexionsschicht ausgebildet.

Das Aufrauen erfolgt durch ein Ausbilden einer lateralen Strukturierung. Dabei wird eine Vielzahl von hervorstehenden Strukturelementen gebildet, die auf der zur nachfolgend ausgebildeten Reflexionsschicht gerichteten Grenzfläche der aktiven Schicht unregelmäßig angeordnet sind.

Die Reflexionsschicht wird nach der Zwischenschicht ausgebildet, so dass eine Grenzfläche am Übergang von der Zwischenschicht zur Reflexionsschicht ausgebildet ist. Diese Grenzfläche ist planar, so dass dort auftreffende Strahlung in die Zwischenschicht zurückreflektiert wird. Die Zwischenschicht ist zwischen der aktiven Schicht und der Reflexionsschicht angeordnet.

Die Schichtenfolge umfasst eine aktive Schicht, eine Halbleiterschicht, welche epitaktisch auf einem Substrat aufgewachsen werden kann. Die Gitterkonstante des Materialsystems wird bevorzugt auf die Gitterkonstante des Substrats angepasst.

Weiter bevorzugt wird das Substrat im Laufe der Herstellung des Körpers abgelöst. Dies hat beispielsweise den Vorteil, dass der strahlungsemittierende Körper mit geringer Höhe hergestellt werden kann. Die Schichtenfolge kann dabei hilfsweise auf einen Zwischenträger aufgebracht werden, der die Schichtenfolge nach dem Ablösen des Substrats stabilisiert. Am Ende kann auch der Zwischenträger abgelöst werden, wobei vorzugsweise an der Stelle des abgelösten Substrats ein Träger angeordnet wird.

Vorzugsweise wird die Grenzfläche mittels natürlicher Lithographie strukturiert. Dieses Verfahren kann zum Beispiel dadurch beschrieben werden, dass auf der Oberfläche der aktiven Schicht Kugeln aufgebracht werden, welche an der Oberfläche der aktiven Schicht anhaften. Mittels eines nachfolgenden Trockenätzverfahrens bleiben an den Orten, an denen die Kugeln anhaften, säulenförmige Strukturelemente stehen. Der Raum zwischen den Strukturelementen wird durch den Trockenätzprozess von der Schichtenfolge abgeätzt.

Strukturelemente mit einer Strukturgröße, die wesentlich größer ist als die Wellenlänge, können mittels nasschemischem Ätzen oder Trockenätzen ausgebildet werden. Hierbei liegt die Strukturgröße erfindungsgemäß im Bereich von > 4 µm.

Es können zur Ausbildung von Strukturelementen auf der Grenzfläche beziehungsweise zur Aufrauung der Grenzfläche bekannte Ätzverfahren eingesetzt werden. Derartige Ätzverfahren sind beispielsweise nasschemisches Ätzen oder Trockenätzen, darunter zu nennen reaktives Ionenätzen, Ionenstrahlätzen oder chemisch unterstütztes Ionenstrahlätzen. Zur Ausbildung von regelmäßigen Grenzflächenstrukturen ist die Photolithographie besonders geeignet.

Erfindungsgemäß wird die Zwischenschicht durch ein Rotationsbeschichtungsverfahren gebildet. Dabei wird ein Wafer auf einem Drehteller fixiert. Mit einer Dosiereinrichtung wird über dem Zentrum des Wafers in gewünschter Menge eine Lösung aufgebracht und der Wafer wird rotiert. Die Lösung verteilt sich dadurch gleichmäßig über die Waferoberfläche und die Oberfläche ist beschichtet. Eventuell überschüssiges Material wird vom Wafer abgeschleudert. Je nach Verfahren bildet sich damit die Oberfläche der Zwischenschicht mehr oder weniger planar aus. Deshalb ist eine Planarisierung vorgesehen, die zum Beispiel durch mechanisches Polieren eine planare Oberfläche an der zu einer noch aufzubringenden Reflexionsschicht gebildeten Grenzschicht erfolgt.

Als Wafer wird eine kreisrunde oder quadratische, zirka 1 mm dicke Scheibe bezeichnet, die das Substrat des strahlungsemittierenden Körpers darstellt. Auf diesem Substrat erfolgt der epitaktische Schichtenaufbau mit photoelektrischen Schichten zur Herstellung einer Vielzahl von strahlungsemittierenden Körpern gemäß der Erfindung.

Im Folgenden ist die Erfindung anhand eines Ausführungsbeispiels und anhand zweier Figuren näher erläutert. Es zeigt:
- Die Figur 1: eine schematische Querschnittsansicht von Schichten des strahlungsemittierenden Körpers, und
- die Figuren 2A bis 2D: eine schematische schrittweise Darstellung einzelner Verfahrensschritte zur Herstellung des strahlungsemittierenden Körpers.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

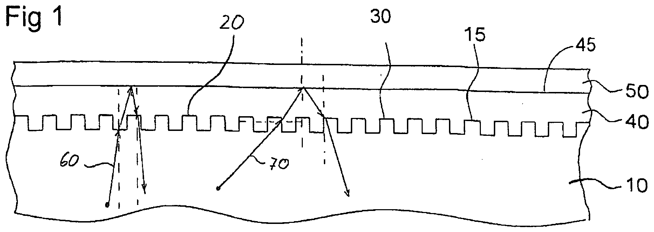

Die Figur 1 zeigt eine aktive Schicht 10, welche an ihrer Grenzfläche 15 eine Strukturierung 20 aufweist. Die Strukturierung 20 ist in der Darstellung gleichförmig aus- und abgebildet, wobei damit eine besondere Ausführungsform, nicht aber eine Beschränkung des Erfindungsgegenstands auf dieses Merkmal der Gleichförmigkeit zu verstehen ist. Die Strukturierung 20 ist gebildet aus einzelnen hervorstehenden Strukturelementen 30, die in einer Vielzahl auf der Oberfläche der aktiven Schicht 10 angeordnet sind und damit die Grenzfläche 15 zu einer Zwischenschicht 40 bilden.

Die Zwischenschicht 40 ist formschlüssig auf der Oberfläche der aktiven Schicht 10 angeordnet. Die Zwischenschicht 40 ist unmittelbar auf der Grenzfläche 15 der aktiven Schicht 10 angeordnet.

Die Zwischenschicht 40 weist einen Brechungsindex auf, der von dem Brechungsindex der aktiven Schicht 10 verschieden ist und weist bevorzugt eine möglichst geringe Absorption auf. Damit wird erreicht, dass eine Ablenkung eines elektromagnetischen Strahls an der Grenzfläche 15 der aktiven Schicht 10 zur Zwischenschicht 40 erfolgt. Die Strukturierung 20 erfüllt dabei die Aufgabe der Streuung. Jeder einzelne elektromagnetische Strahl verfolgt in einem Medium wie der aktiven Schicht 10 eine bestimmte Richtung. Bei einem Übergang von einem Medium in ein anders Medium, dessen Brechzahl sich von dem des ersten unterscheidet; an der Grenzfläche 15 von der aktiven Schicht 10 in die Zwischenschicht 40 wird ein Teil des elektromagnetischen Strahles reflektiert, ein weiterer Teil wird gemäß dem Snelliusschen Brechungsgesetz abgelenkt. Diese Ablenkung erfolgt beim Übertritt in ein Medium mit größerer Brechzahl zum Lot der Grenzfläche hin und beim Übertritt in ein Medium mit kleinerer Brechzahl vom Lot der Grenzfläche weg. Darüber hinaus kommt es zu einer Totalreflexion, wenn der Einfallswinkel des elektromagnetischen Strahles einen bestimmten Wert überschreitet. Durch die Strukturierung 20 der Grenzfläche 15 erfolgt somit eine Ablenkung in verschiedene Richtungen und damit eine Streuung der elektromagnetischen Strahlen.

Die Zwischenschicht 40 ist an ihrer zu einer Reflexionsschicht 50 gebildeten Grenzfläche 45 mit einer planaren Oberfläche ausgebildet. Die Grenzfläche 45 ist gebildet durch eine Reflexionsschicht 50, die aus Metall gebildet ist.

Die Reflexionsschicht 50 ist, wenn sie eine metallische Schicht ist mit Titan-Silber-Titan gebildet, da diese Materialien bei einem InGaAlP aufweisenden strahlungsemittierenden Körper besonders geeignet sind.

Die Dicke der Reflexionsschicht 50 wird so ausgewählt, dass die auftreffende Strahlung die Reflexionsschicht 50 nicht durchdringt, sondern an ihr im Wesentlichen reflektiert wird. Vorzugsweise liegt die Dicke der Reflexionsschicht 50 im Bereich von etwa 150 nm. Die Reflexionsschicht 50 ist zugleich elektrisch leitend, wodurch vorteilhafterweise eine Versorgung des strahlungsemittierenden Körpers mit elektrischer Energie über die Reflexionsschicht 50 möglich wird.

Die Reflexionsschicht 50 weist an der gemeinsamen Grenzfläche 45 mit der Zwischenschicht 40 eine planare Oberfläche auf. Diese wird zum Beispiel mittels eines mechanischen Planarisierungsverfahrens, wie zum Beispiel mechanisches Polieren und nachfolgendem Aufbringen einer Metallschicht, gebildet. Auch sind andere Verfahren zur Erzeugung einer planaren Oberfläche möglich. Beispiele dafür sind zum Beispiel die Verwendung eines niederigschmelzenden Materials, das bei einer thermischen Behandlung bei Temperaturen von weniger als 500° C zu fließen beginnt und somit eine planare Oberfläche ausbildet. Eine andere Möglichkeit zur Herstellung einer planaren Oberfläche ist mit der sogenannten Ion-Beam-Technologie beziehungsweise der Etch-Back-Technologie gegeben. Bei der Etch-Back-Technologie wird die raue Oberfläche mit einem Photolack überzogen und dann mittels "Ion Beam", einem Ionenstrahl, "zurückgeätzt" (Etch-Back), so dass eine glatte Oberfläche entsteht.

Die an der Reflexionsschicht 50 auftretende Richtungsumkehr der auftreffenden Strahlung beruht auf Reflexion an der Grenzfläche 45 der Zwischenschicht 40 zur Reflexionsschicht 50.

Ein in der aktiven Schicht 10 erzeugter elektromagnetischer Strahl 60, welcher sich zur Grenzschicht 15 hin ausbreitet, wird an der Grenzschicht 15 abgelenkt. Nach dem Durchtritt durch die Grenzschicht 15 breitet sich der elektromagnetische Strahl 60 in der Zwischenschicht 40 in der abgelenkten Richtung weiter aus, bis er die Grenzschicht 45 der Reflexionsschicht 50 erreicht. An dieser wird der elektromagnetische Strahl 60 reflektiert und breitet sich in Richtung der Grenzschicht 15 weiter aus. Bei dem erneuten Durchdringen der Grenzschicht 15 wird der elektromagnetische Strahl 60 erneut abgelenkt und durchdringt nun die aktive Schicht 10, bis er diese und dann den strahlungsemittierenden Körper verlässt. Ein ebenfalls in der aktiven Schicht 10 erzeugter elektromagnetischer Strahl 70, mit einer zum Strahl 60 verschiedenen Ausbreitungsrichtung, trifft in einem anderen Winkel und an einer anderen Stelle auf die Grenzschicht 15 und wird nach den gleichen physikalischen Gesetzmäßigkeiten abgelenkt und letztendlich an der Grenzschicht 45 reflektiert. Durch die Struktur der Grenzschicht 15 erfolgt somit eine Streuung aller durch die Grenzschicht 15 dringenden elektromagnetischen Strahlen.

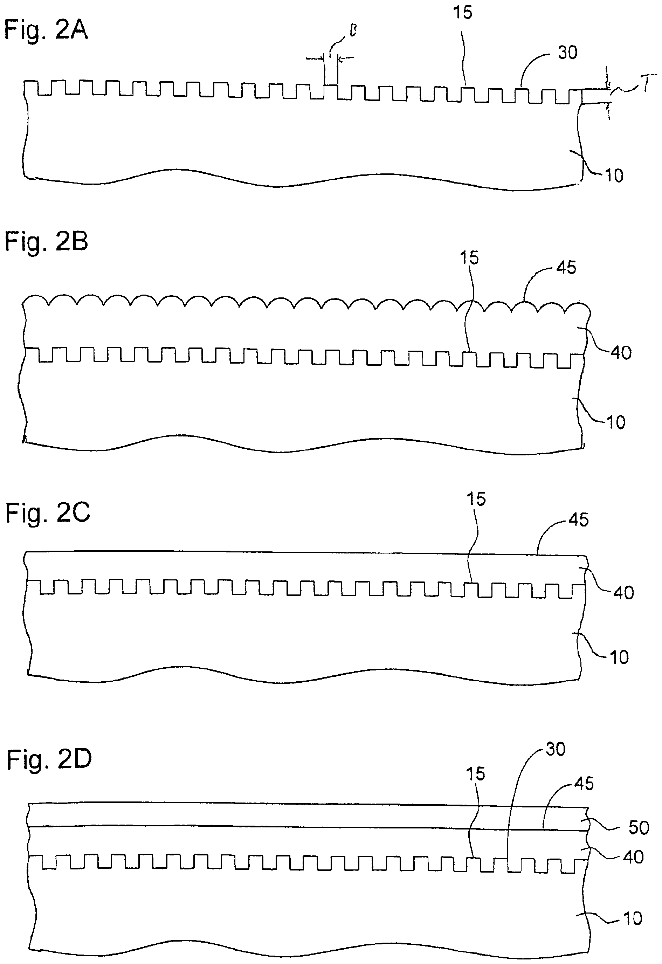

Die Figur 2 zeigt einzelne Verfahrensschritte zur Bildung eines strahlungsemittierenden Körpers gemäß dem vorstehend beschriebenen Prinzips.

Dabei zeigt die Figur 2A die aktive Schicht 10 mit ihrer strukturierten Oberfläche, welche die Grenzfläche 15 zur Zwischenschicht 40 bildet. Die Strukturgröße der Strukturelemente 30 ist größer als die Wellenlänge der emittierten elektromagnetischen Strahlung. Die Strukturgröße betrifft die Breite B und die Tiefe T der Strukturelemente 30. Derartige Strukturelemente 30 können mittels eines der bereits vorstehend genannten Verfahren ausgebildet werden. In der Darstellung sind die Strukturelemente 30 gleichförmig ausgebildet. Dies ist eine Sonderform der Strukturierung 20, welche sich zum Beispiel durch ein photolithografisches Verfahren mit anschließendem Ätzprozess bilden lässt. Mittels eines natürlichen lithografischen Verfahrens lassen sich auch unterschiedlich große und unregelmäßig angeordnete Strukturelemente 30 auf der Grenzfläche 15 bilden.

Figur 2B zeigt die aktive Schicht 10 mit ihrer strukturierten Oberfläche, welche die Grenzfläche 15 zur Zwischenschicht 40 bildet und der unmittelbar und formschlüssig darauf angeordneten Zwischenschicht 40. Durch die Zwischenschicht 40 kann die mechanische Stabilität der strahlungsemittierenden Körpers verbessert und die elektrische Leitfähigkeit beeinflusst werden.

Um einen rückseitigen elektrischen Kontakt zu ermöglichen, kann die Zwischenschicht 40 ein leitfähiges Metalloxid, beispielsweise ITO oder ZnO enthalten. Unebenheiten an der zur Reflexionsschicht 50 gerichteten Oberfläche der Zwischenschicht 40 werden durch einen Planarisierungsschritt beseitigt. Ein Beispiel für einen derartigen Planarisierungsschritt ist mechanisches Polieren.

Nach dem Planarisieren ist eine in Figur 2D gezeigte planare Oberfläche, an der Zwischenschicht 40 gebildet. Auf diese wird die Reflexionsschicht 50 aufgebracht.

## Patentansprüche

1. Verfahren zur Herstellung eines InGaAlP aufweisenden strahlungsemittierenden Körpers mit den folgenden Schritten:
- Ausbilden einer Schichtenfolge mit einer aktiven Schicht (10) zur Erzeugung von elektromagnetischer Strahlung auf einem Substrat,
- Aufrauen einer Grenzfläche (15) der aktiven Schicht (10), sodass die aktive Schicht (10) auf der dem Substrat gegenüberliegenden Seite eine Aufrauung aufweist und die Aufrauung eine laterale Strukturierung (20) mit einer Vielzahl von hervorstehenden Strukturelementen (30) umfasst und die Strukturelemente (30) mittels nasschemischem Ätzen oder Trockenätzen mit einer Strukturgröße im Bereich von > 4 µm ausgebildet werden,
- Ausbilden einer elektrisch leitfähigen Zwischenschicht (40) aus einem transparenten leitfähigen Oxid durch ein Rotationsbeschichtungsverfahren unmittelbar und formschlüssig an der aktiven Schicht (10), wobei die Zwischenschicht (40) für die erzeugte Strahlung durchlässig ist,
- Planarisieren der Zwischenschicht (40), sodass eine planare Oberfläche (45) entsteht,
- Ausbilden einer Reflexionsschicht (50) unmittelbar und formschlüssig an der planaren Oberfläche (45) der Zwischenschicht (40), wobei die Reflexionsschicht (50) eine Titan-Silber-Titan Schichtenfolge umfasst.

## Claims

1. A method for producing a radiation-emitting body including InGaG, comprising the following steps of:
- forming a layer sequence having an active layer (10) for generating electromagnetic radiation on a substrate,
- roughening of an interface (15) of the active layer (10) so that the active layer (10) has a roughening on the side opposite the substrate, and the roughening has a lateral structuring (20) having a plurality of protruding structural elements (30), and the structural elements (30) are produced by means of wet-chemical etching or dry etching with a structure size in the region of > 4 µm,
- forming an electrically conductive intermediate layer (40) made of a transparent conductive oxide directly and positively interlocking on the active layer (10) by means of a spin coating method, wherein the intermediate layer (40) is permeable to the generated radiation,
- planarizing the intermediate layer (40) so that a planar surface (45) is produced,
- forming a reflection layer (50) directly and positively interlocking on the planar surface (45) of the intermediate layer (40), wherein the reflection layer (50) comprises a titanium-silver-titanium layer sequence.

## Revendications

1. Procédé en vue de la fabrication d'un corps émetteur de rayonnement présentant de l'InGaAlP, avec les étapes suivantes :
- Constitution d'une succession de couches avec une couche active (10) en vue de la production de rayonnement électromagnétique sur un substrat,
- Grattage d'une surface limite (15) de la couche active (10), de sorte que la couche active (10) présente sur le côté opposé au substrat un grattage et le grattage comporte une structuration latérale (20) avec une multitude d'éléments structurels en saillie (30) et que les éléments structurels (30) sont constitués avec une dimension de structure dans la gamme de >4 µm au moyen d'une gravure chimique par voie humide ou d'une gravure sèche,
- Constitution d'une couche intermédiaire conductible électriquement (40) à partir d'un oxyde transparent conductible par un procédé de revêtement centrifuge directement et mécaniquement sur la couche active (10), sachant que la couche intermédiaire (40) est perméable au rayonnement généré,
- Aplanissement de la couche intermédiaire (40), de sorte qu'une surface planaire (45) apparaît,
- Constitution d'une couche de réflexion (50) directement et mécaniquement sur la surface planaire (45) de la couche intermédiaire (40), sachant que la couche de réflexion (50) comporte une succession de couches de titane-argent-titane.
